(19) Europäisches Patentamt
European Patent Office
Office européen des brevets

(11) EP 1 974 472 B1

(12) **FASCICULE DE BREVET EUROPEEN**

(45) Date de publication et mention de la délivrance du brevet:
**15.04.2009 Bulletin 2009/16**

(21) Numéro de dépôt: **07718051.1**

(22) Date de dépôt: **18.01.2007**

(51) Int Cl.:
***H03M 13/29*** *(2006.01)*

(86) Numéro de dépôt international:
**PCT/FR2007/050664**

(87) Numéro de publication internationale:
**WO 2007/083066 (26.07.2007 Gazette 2007/30)**

(54) **PROCEDES D'ENCODAGE ET DE DECODAGE RAPIDES ET DISPOSITIFS ASSOCIES**

SCHNELLE CODIERUNGS- UND DECODIERUNGSVERFAHREN UND ZUGEHÖRIGE VORRICHTUNGEN

FAST ENCODING AND DECODING METHODS AND RELATED DEVICES

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **19.01.2006 FR 0650196**

(43) Date de publication de la demande:
**01.10.2008 Bulletin 2008/40**

(73) Titulaire: **France Télécom**
**75015 Paris (FR)**

(72) Inventeurs:
- **DORE, Jean-Baptiste**
  **F-92794 Issy Les Moulineaux Cedex 9 (FR)**
- **HAMON, Marie-Hélène**
  **F-92794 Issy Les Moulineaux Cedex 9 (FR)**
- **PENARD, Pierre**
  **F-92794 Issy Les Moulineaux Cedex 9 (FR)**

(74) Mandataire: **Desormiere, Pierre-Louis et al**
**Cabinet Beau de Loménie**
**158, rue de l'Université**
**75340 Paris Cedex 07 (FR)**

(56) Documents cités:
**WO-A-99/34521**

- **YIGE WANG ET AL: "Reduced latency turbo decoding" 6TH WORKSHOP ON SIGNAL PROCESSING ADVANCES IN WIRELESS COMMUNICATIONS, 2005 NEW YORK, NY, USA JUNE 2-8, 2005, PISCATAWAY, IEEE, 2 juin 2005 (2005-06-02), pages 930-934, XP010834653 ISBN: 0-7803-8867-4**
- **CHUGG K M ET AL: "A New Class of Turbo-like Codes with Universally Good Performance and High-Speed Decoding" MILITARY COMMUNICATIONS CONFERENCE, 2005. MILCOM 2005. IEEE ATLANTIC CITY, NJ, USA 17-20 OCT. 2005, PISCATAWAY, NJ, USA,IEEE, 17 octobre 2005 (2005-10-17), pages 1-10, XP010901704 ISBN: 0-7803-9393-7 cité dans la demande**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

**Description**

Domaine technique de l'invention

L'invention se rapporte au domaine des communications numériques et concerne plus particulièrement un procédé d'encodage et de décodage à haut débit selon, par exemple, un code de type LDPC (Low Density Parity Check), ainsi que des dispositifs d'encodage et de décodage associés.

Arrière-plan de l'invention

Actuellement, les systèmes de communication numérique les plus performants s'appuient sur des systèmes dans lesquels les données à transmettre sont protégées par un codage de canal très performant et sont décodées itérativement par un décodeur à sortie pondérée. Le codage de canal ou codage correcteur d'erreurs permet d'améliorer la qualité de la transmission, en insérant dans le message à transmettre des éléments binaires dits de redondance suivant une loi donnée.

Dans le domaine des transmissions numériques et plus particulièrement lorsque le canal de transmission est de type hertzien, la fonction principale de ces codes correcteurs est de permettre la levée des ambiguïtés apportées par le canal de transmission sur le message transmis. Le décodeur de canal, qui connaît la loi de codage utilisée à l'émission, vient vérifier si cette loi est toujours respectée en réception. Si ce n'est pas le cas, il détecte la présence d'erreurs de transmissions.

Le gain en performance apporté par ces codes peut être affecté à la réduction de consommation des terminaux ou à l'augmentation du volume d'informations transmis.

Récemment, de nombreux travaux ont été réalisés dans le domaine du codage de canal en utilisant des codes correcteurs d'erreurs dits codes LDPC (Low Density Parity Check).

Ces codes sont actuellement proposés au sein des instances de normalisation, par exemple, dans le cadre de la normalisation du protocole de communication IEEE 802.11n destiné aux futurs réseaux d'accès sans fil (WLAN) à très hauts débits ou encore dans le cadre de la normalisation du protocole IEEE 802.16e (WiMAX Mobile).

Le document US 2005 0216819 décrit un procédé et un dispositif d'encodage et de décodage de codes du type Turbo-codes série. Ces codes sont générés par la concaténation en série d'un code externe, d'un entrelacement, d'un code de parité et d'un code interne.

Dans le document intitulé « A New Class of Turbo-like Codes with Universally Good Performance and High-Speed Decoding » (IEEE Milcom 2005, October 2005), Keith M. Chugg *et al.* décrivent une nouvelle classe de codes dénommés S-SCP (Systematic and Serial Concatenated Parity) et notamment les codes F-LDPC (Flexible LDPC) pour lesquels la matrice de contrôle de parité H peut s'écrire sous la forme suivante :

$$H \equiv \begin{pmatrix} S & V & 0 \\ 0 & I & G \end{pmatrix} \qquad \textbf{Eq. 1}$$

où I est une matrice identité, G et S sont des matrices bi-diagonales et V est le produit de trois matrices selon le document de normalisation IEEE 802.11-04/0953r4 par K. Chugg *et al.* (802.11 Task Group N, September 2004). La forme de cette matrice V présente une limitation vis-à-vis du débit d'encodage et de décodage.

Les figures 1A et 1B représentent respectivement la structure d'un encodeur 10 et d'un décodeur 20 selon l'état actuel de la technique. Conformément à la figure 1A, l'encodeur 10 comprend un codeur externe 3, un entrelaceur 5, un convertisseur série-parallèle 7, un codeur de parité 9 et un codeur interne 11. Le code généré par cet encodeur 10 résulte de la concaténation en série des codes successivement générés par le codeur externe 3, le codeur de parité 9 et le codeur interne 11.

Selon cette architecture, une séquence de bits d'entrée De est d'abord entièrement codée par le codeur externe 3, puis entrelacée par l'entrelaceur 5 pour former une séquence de données entrelacées Di. Le convertisseur série-parallèle 7 permet de paralléliser la séquence de données entrelacées Di. Le codeur de parité 9 réalise ensuite un calcul de parité en effectuant la somme modulo-2 de J bits extraits en sortie du convertisseur série-parallèle 7. La séquence de données en sortie du codeur de parité 9 est ensuite codée par le codeur interne 11.

La figure 1B représente la structure d'un décodeur 20 comprenant un décodeur externe 15, un entrelaceur/désentrelaceur 17, un décodeur de parité 19, un décodeur interne 21.

Le décodage mis en oeuvre par le décodeur 20 est réalisé itérativement sur des données souples. Les données souples correspondant à la partie systématique du code sont utilisées par le décodeur externe 15 pour obtenir une information extrinsèque I1 qui est ensuite entrelacée par l'entrelaceur 17 pour donner une information I2 utilisable par

le décodeur de parité 19 qui calcule des nouvelles informations extrinsèques I3. A partir de ces informations I3 et des données souples I4 correspondant à la partie redondante du code, le décodeur interne 21 calcule un message I5 qui est ensuite décodé par le décodeur de parité 19 pour former un message I6 qui est transmis au désentrelaceur 17. Une fois le message I6 désentrelacé en un message I7 par le désentrelaceur 17, une itération du procédé d'encodage est alors accomplie.

L'inconvénient majeur de l'encodeur 10 (respectivement décodeur 20) est la latence introduite par son architecture de type série, ayant pour effet de limiter le débit d'encodage (respectivement décodage).

Les figures 2A et 2B représentent respectivement l'ordonnancement des différentes étapes du procédé d'encodage et du procédé de décodage réalisés respectivement par l'encodeur 10 et le décodeur 20.

Dans le cas classique d'encodage selon des codes concaténés en série, chaque codeur constitutif du dispositif d'encodage 10, c'est-à-dire le codeur externe 3, le codeur de parité 9 ou le codeur interne 11, est activé à condition que le codeur qui le précède ait entièrement réalisé sa tâche.

La figure 2A représente très schématiquement l'ordonnancement dans le temps (en abscisse) des tâches (en ordonnée) constitutives du procédé d'encodage mis en oeuvre par l'encodeur 10, ces tâches étant réalisées successivement par le codeur externe 3, le codeur de parité 9 et le codeur interne 11 de la figure 1A.

Selon cet ordonnancement, une première étape de codage E10 est réalisée par le codeur externe 3 pendant une durée T10. Lorsque l'étape E10 est totalement terminée, le codeur de parité 9 réalise une étape de calcul E30 pendant une durée T30. Une fois l'étape E30 terminée, celle-ci est suivie d'une étape de codage E50 effectuée par le codeur interne 11 pendant une durée T50. La durée nécessaire pour encoder une séquence de bits en entrée de l'encodeur 10 est donc égale à la somme T10+T30+T50. Ainsi cet ordonnancement des tâches limite le débit d'encodage de l'encodeur 10.

La figure 2B représente une répartition temporelle (en abscisse) des tâches (en ordonnée) de décodage mis en oeuvre par le décodeur 20 de la figure 1B, lors d'une itération de ce procédé.

Conformément à la figure 2B, le décodeur externe 15 réalise une étape E70 de décodage pendant une durée T70. Une fois l'étape E70 terminée, le décodeur de parité 19 réalise une étape de calcul E90 pendant une durée T90. Une fois l'étape E70 terminée, le décodeur interne 21 réalise une étape E110 pendant une durée T110. Le décodeur de parité 19 réalise ensuite une étape E130 pendant la durée T130. Ainsi, la durée T d'une itération du procédé de décodage est donc égale à la somme des durées de chacune des étapes décrites ci-dessus E70, E90, E110, E130, soit la durée T = T70 + T90 + T110 + T130.

Les procédés d'encodage et de décodage décrits ci-dessus sont limités en terme de débits en raison du type de l'ordonnancement des différentes tâches constitutives des procédés d'encodage et de décodage.

De plus, les ressources matérielles (« hardware ») de l'encodeur 10 et du décodeur 20 ne sont pas utilisées de manière optimale, dans le sens où chaque fonction de traitement au sein du codeur 10 et du décodeur 20 n'est pas utilisée de manière continue dans le temps.

<u>Objet et résumé de l'invention</u>

La présente invention a donc pour but principal de remédier aux inconvénients précités en fournissant un procédé d'encodage et de décodage ayant la propriété d'encoder et de décoder une séquence de données très rapidement et sans perte significative de performance par rapport aux procédés connus.

Ces buts sont atteints grâce à un procédé d'encodage d'une séquence de bits d'entrée S0 en une séquence de bits codés S, comprenant les étapes suivantes :

- une première étape de codage appliquée sur les bits de la séquence de bits d'entrée S0, selon un premier code ;
- une étape d'entrelacement destinée à entrelacer, par des moyens d'entrelacement, les bits issus du premier code;
- une deuxième étape de codage dit de parité, appliquée sur les bits issus des moyens d'entrelacement, selon un deuxième code, pour générer la séquence de bits codés S, de sorte que la deuxième étape de codage de parité débute après l'entrelacement d'un nombre $\Delta$ prédéterminé de bits. Ce nombre $\Delta$ prédéterminé de bits est compris entre un premier nombre inférieur $\Delta i$ de bits dépendant d'au moins un paramètre de l'étape d'entrelacement, et un premier nombre supérieur $\Delta s$ de bits correspondant au nombre total de bits devant être traités lors de l'étape d'entrelacement.

Un tel procédé d'encodage permet de commencer la deuxième étape de codage de parité sans attendre la fin de l'étape d'entrelacement, la deuxième étape de codage s'effectuant en parallèle de l'étape d'entrelacement et avec un décalage relatif de $\Delta$ bits.

Ainsi, ce procédé permet de paralléliser les étapes de codage de parité et d'entrelacement sans avoir à dupliquer toutes les fonctions et les mémoires associées au traitement des tâches liées à ces étapes, contrairement au cas d'une architecture dans laquelle l'ordonnancement de ces tâches est séquentiel.

Ce procédé permet ainsi de réduire la complexité de la mise en oeuvre du procédé d'encodage, avec des performances supérieures ou égales par rapport à celles de procédés connus.

Selon une autre caractéristique de l'invention, la deuxième étape de codage de parité débute après l'encodage d'un nombre prédéterminé $\Delta'$ de bits selon la première étape de codage. Ce nombre prédéterminé $\Delta'$ de bits est compris entre un second nombre inférieur $\Delta i'$ de bits dépendant d'au moins un paramètre de l'étape d'entrelacement, et un second nombre supérieur $\Delta s'$ de bits correspondant au nombre total de bits devant être traités lors de la première étape de codage.

Ainsi, ce procédé d'encodage permet de commencer la deuxième étape de codage de parité sans attendre la fin de la première étape de codage de parité, la deuxième étape de codage s'effectuant en parallèle de la première étape de codage et avec un décalage de $\Delta'$ bits.

Le décalage entre le début de la première étape de codage et le début de l'étape d'entrelacement peut être ajusté et correspond au minimum à un décalage de 1 bit. ($\Delta' - \Delta \geq 1$)

Avantageusement, l'étape d'entrelacement peut être effectuée conjointement avec la deuxième étape de codage de parité.

Selon une autre caractéristique de l'invention, l'étape d'entrelacement comporte une première fonction $\pi$ d'entrelacement par bits associant au $i^{ème}$ bit issu du premier code, le $\pi(i)^{ème}$ bit d'une séquence de bits entrelacés, de sorte que l'entrelacement des k premiers bits fournisse au moins les m premiers bits de la séquence de bits entrelacés.

Ainsi, cette caractéristique permet de commencer la deuxième étape de codage de parité sans attendre la fin de l'étape d'entrelacement.

Selon une autre caractéristique de l'invention, l'étape d'entrelacement et la deuxième étape de codage de parité sont réalisées au moyen d'une matrice V de contrôle de parité quasi-cyclique comprenant une pluralité de sous-matrices identités, de la forme suivante :

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

telle que pour tout i compris entre 1 et $m_1$ et pour tout j compris entre 1 et $m_2$, si le coefficient c(i,j) est strictement négatif alors la sous-matrice $I[c(i,j)]$ est une matrice nulle, sinon ladite sous-matrice $I[c(i,j)]$ est une matrice identité permutée circulairement de c(i,j) positions.

La forme quasi-cyclique de la matrice de contrôle de parité V permet une parallélisation entre l'étape d'entrelacement et la deuxième étape de codage de parité, qui s'effectuent dans ce cas, de manière conjointe.

Selon une autre caractéristique de l'invention, l'étape d'entrelacement comporte une seconde fonction $\lambda$ d'entrelacement permettant d'associer un premier ensemble de paquets de $m_1$ bits issus du premier code, à un second ensemble de paquets de J bits de la séquence de bits entrelacés, de sorte que les bits appartenant à un même paquet de J bits de la séquence de bits entrelacés proviennent de paquets distincts du premier ensemble de paquets de $m_1$ bits.

Cet entrelacement par paquets permet d'éviter l'accès à un même espace mémoire au même instant lors de l'étape de codage de parité. Ce type d'entrelacement permet donc d'augmenter le débit d'encodage en minimisant la latence liée aux conflits d'accès à la mémoire.

Selon une particularité de l'invention, pour une même ligne de la matrice V de contrôle de parité, les coefficients c(i,j) positifs sont différents.

Afin d'éviter les conflits d'accès mémoire, il est nécessaire que plusieurs bits intervenant dans une même équation de parité contenue dans la matrice V, ne proviennent pas d'une même zone mémoire. Cette condition se traduit par la relation mathématique suivante portant sur les coefficients positifs de la matrice V:

$$\forall c(i,j) \geq 0 \; et \; \forall c(i,k) \geq 0 : c(i,j) \geq c(i,k) \text{ pour } j \neq k$$

Autrement dit, cette condition garantit que deux accès simultanés à une même mémoire sont impossibles, permettant ainsi d'accroître le débit d'encodage en réduisant la latence liée aux conflits d'accès mémoire.

Selon une particularité de l'invention, ledit au moins un paramètre déterminant les nombres de bits $\Delta$ et $\Delta'$ est fonction des coefficients c(i,j) positifs de ladite matrice de contrôle de parité V.

Selon une autre caractéristique de l'invention, le premier code de la première étape de codage est composé

d'une première pluralité de codes indépendants.

Ainsi, le premier code peut être lui-même parallélisé, permettant ainsi une augmentation supplémentaire du débit d'encodage au niveau de la première étape d'encodage.

Selon une autre caractéristique de l'invention, le procédé d'encodage comporte une troisième étape de codage, selon un troisième code, appliquée sur des bits issus de la deuxième étape de décodage de parité, de sorte que la troisième étape de codage débute à partir de l'encodage d'au moins un bit issu de la deuxième étape de décodage de parité.

Ainsi, le troisième code de la troisième étape de codage peut être choisi de sorte qu'il présente des propriétés supplémentaires par rapport au premier code de la première étape de codage, par exemple, de manière à accroître le pouvoir correcteur du code formé par la concaténation des premier, deuxième et troisième codes.

Avantageusement, le troisième code de la troisième étape de codage est composé d'une seconde pluralité de codes indépendants. Ainsi, le troisième code peut être lui-même parallélisé, permettant ainsi une augmentation supplémentaire du débit d'encodage, au niveau de la troisième étape de codage.

L'invention vise également un procédé de décodage d'un signal de réception numérisé comprenant une séquence de données formée d'une première partie correspondant à des informations à transmettre et d'une seconde partie comportant des données de redondance, comprenant :

- une première étape de décodage appliquée sur les données de la première partie ;
- une étape d'entrelacement, par des moyens d'entrelacement, destinée à entrelacer des données issues de la première étape de décodage ; et
- une deuxième étape de décodage dit de parité, appliquée sur des données issues des moyens d'entrelacement.

Avantageusement la deuxième étape de décodage de parité débute après l'entrelacement d'un nombre prédéterminé Δ de données. Ce nombre prédéterminé Δ de données est compris entre un premier nombre inférieur Δi de données dépendant d'au moins un paramètre de l'étape d'entrelacement, et un premier nombre supérieurΔs de données correspondant au nombre total de données devant être traitées lors de l'étape d'entrelacement.

Ainsi, ce procédé permet de paralléliser les étapes de <u>dé</u>codage de parité et d'entrelacement sans avoir à dupliquer toutes les fonctions et les mémoires associées au traitement des tâches liées à ces étapes.

Selon une autre caractéristique de l'invention, la deuxième étape de décodage de parité débute après le décodage d'un nombre prédéterminé Δ' de données selon la première étape de décodage. Ce nombre prédéterminé Δ' de données est compris entre un second nombre inférieur Δi' de données dépendant d'au moins un paramètre de l'étape d'entrelacement, et un second nombre supérieur Δs' de données correspondant au nombre total de données devant être traitées lors de la première étape de décodage.

Selon une autre caractéristique de l'invention, le procédé de décodage comporte une troisième étape de décodage de manière à décoder des données issues de la deuxième étape de décodage de parité, la troisième étape de décodage débutant à partir du décodage d'au moins une donnée issue de la deuxième étape de décodage de parité.

Selon une autre caractéristique de l'invention, l'étape d'entrelacement est effectuée conjointement avec la deuxième étape de décodage de parité.

Selon une autre caractéristique de l'invention, l'étape d'entrelacement et la deuxième étape de décodage sont réalisées au moyen d'une matrice V de contrôle de parité quasi-cyclique comprenant une pluralité de sous-matrices identités, de la forme suivante :

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

telle que pour tout i compris entre 1 et $m_1$ et pour tout j compris entre 1 et $m_2$, si le coefficient c(i,j) est strictement négatif alors la sous-matrice $I[c(i,j)]$ est une matrice nulle, sinon ladite sous-matrice $I[c(i,j)]$ est une matrice identité permutée circulairement de c(i,j) positions.

Selon une autre caractéristique de l'invention, pour une même colonne de la matrice V de contrôle de parité, les coefficients c(i,j) positifs sont différents.

Afin d'éviter tout conflit d'accès mémoire qui engendrerait de la latence et qui se traduirait par une baisse du débit de décodage, il est nécessaire qu'une variable n'intervienne pas plus d'une seule fois dans un groupe de $m_2$ équations de parité contenues dans la matrice V, ce qui se traduit sur les coefficients positifs de la matrice V par la relation mathématique suivante :

$$\forall c(i,j) \geq 0 \;\; et \;\forall c(i,j+1) : c(i,j) \neq c(i+1,j) \;\forall i, \forall j$$

Selon une autre caractéristique de l'invention, ledit au moins un paramètre déterminant les nombres de données Δ et Δ' est fonction des coefficients c(i,j) positifs de la matrice V de contrôle de parité.

L'invention vise également un dispositif d'encodage d'une séquence de bits d'entrée S0 en une séquence de bits S codés, comprenant :

- des premiers moyens de codage destinés à coder les bits de la séquence de bits d'entrée S0, selon un premier code;
- des moyens d'entrelacement destinés à entrelacer des bits issus des premiers moyens de codage ;
- des deuxièmes moyens de codage dit de parité, destinés à coder des bits issus des moyens d'entrelacement, selon un deuxième code, pour générer la séquence de bits codés S.

Avantageusement, ces moyens d'entrelacement sont adaptés de sorte que les deuxièmes moyens de codage de parité débutent la séquence de bits codés S après l'entrelacement d'un nombre Δ prédéterminé de bits. Ce nombre Δ prédéterminé de bits est compris entre un premier nombre inférieur Δi de bits dépendant d'au moins un paramètre des moyens d'entrelacement, et un premier nombre supérieur Δs de bits correspondant au nombre total de bits devant être traités par les moyens d'entrelacement.

Le dispositif d'encodage peut être notamment adapté pour la mise en oeuvre du procédé d'encodage tel que décrit précédemment.

L'invention vise également un dispositif de décodage d'un signal de réception numérisé comprenant une séquence de données formée d'une première partie D correspondant à des informations à transmettre et d'une seconde partie C comportant des données de redondance. Ce dispositif comprend :

- des premiers moyens de décodage des données de la première partie D;
- des moyens d'entrelacement destinés à entrelacer des bits issus des premiers moyens de décodage ; et
- des deuxièmes moyens de décodage dit de parité destinés à décoder des bits issus des moyens d'entrelacement.

Les moyens d'entrelacement sont adaptés de sorte que les deuxièmes moyens de décodage de parité débutent le décodage de parité après l'entrelacement d'un nombre prédéterminé Δ de données. Ce nombre prédéterminé Δ de données est compris entre un premier nombre inférieur Δi de données dépendant d'au moins un paramètre des moyens d'entrelacement, et un premier nombre supérieur Δs de données correspondant au nombre total de données devant être traitées par les moyens d'entrelacement.

Le dispositif de décodage peut être notamment adapté pour la mise en oeuvre du procédé de décodage tel que décrit précédemment.

L'invention vise également un produit programme d'ordinateur téléchargeable depuis un réseau de communication et/ou stocké sur un support lisible par ordinateur et/ou exécutable par un microprocesseur, comprenant des instructions de codes de programme pour l'exécution des étapes du procédé d'encodage décrit ci-dessus, lorsqu'il est exécuté sur un ordinateur.

L'invention vise également un produit programme d'ordinateur téléchargeable depuis un réseau de communication et/ou stocké sur un support lisible par ordinateur et/ou exécutable par un microprocesseur, comprenant des instructions de codes de programme pour l'exécution des étapes du procédé de décodage décrit ci-dessus, lorsqu'il est exécuté sur un ordinateur.

<u>Brève description des dessins</u>

D'autres caractéristiques et avantages de la présente invention ressortiront de la description faite ci-dessous, en référence aux dessins annexés qui en illustrent un exemple de réalisation dépourvu de tout caractère limitatif. Sur les figures :

- les figures 1A et 1B déjà décrites précédemment représentent respectivement un encodeur et un décodeur de l'art antérieur ;
- les figures 2A et 2B déjà décrites précédemment représentent respectivement l'ordonnancement des étapes d'encodage et de décodage selon l'art antérieur ;

- la figure 3 représente l'ordonnancement des étapes d'encodage selon l'invention ;
- les figures 4 et 7 représentent respectivement l'ordonnancement des étapes d'encodage et de décodage selon un mode de réalisation de la présente invention ;
- les figures 5A et 5B représentent respectivement un entrelacement par bits et un entrelacement par paquets, selon la présente invention ;
- les figures 6 et 8 illustrent de manière schématique, respectivement un dispositif d'encodage et un dispositif de décodage selon l'invention ; et
- la figure 9 illustre schématiquement un système informatique mettant en oeuvre le dispositif d'encodage et/ou d'encodage selon l'invention.

Description détaillée de modes de réalisation

La figure 3 illustre l'ordonnancement dans le temps (abscisse) des étapes (ordonnée) d'un procédé d'encodage selon l'invention, permettant d'encoder une séquence de bits d'entrée S0 en une séquence de bits codés S.

Ce procédé comporte une première étape E1 de codage appliquée sur les bits de la séquence de bits d'entrée S0, selon un premier code. Les bits issus de ce premier code sont entrelacés par des moyens d'entrelacement 33 (voir Figure 6), lors d'une étape d'entrelacement E3.

Les bits issus des moyens d'entrelacement 33 sont encodés selon une deuxième étape E4 de codage dit de parité, selon un deuxième code, pour générer la séquence de bits codés S.

Avantageusement, la deuxième étape E4 de codage de parité débute après l'entrelacement d'un nombre $\Delta$ prédéterminé de bits. Ce nombre $\Delta$ prédéterminé de bits est compris entre un premier nombre inférieur $\Delta i$ de bits dépendant d'au moins un paramètre de l'étape d'entrelacement E3, et un premier nombre supérieur $\Delta s$ de bits correspondant au nombre total de bits devant être traités lors de l'étape d'entrelacement E3.

La figure 4 illustre à titre d'exemple l'ordonnancement dans le temps (en abscisse) des différentes étapes (en ordonnée) constitutives d'un procédé d'encodage selon un mode de réalisation de l'invention.

Ce procédé d'encodage permet d'encoder une séquence de bits d'entrée S0 en une séquence de bits codés S' selon les étapes suivantes.

Une première étape de codage (dit codage externe) E1 est appliquée sur des bits de la séquence de bits d'entrée S0, par des premiers moyens de codage 30 (dénommés aussi codeur externe 30), selon un premier code (dit code externe) décrit par une matrice de contrôle de parité G1 du code externe.

Une étape d'entrelacement E3 est destinée à entrelacer par des moyens d'entrelacement 33 (dénommés aussi « entrelaceur » 33), des bits issus du code externe, selon un double entrelacement par bits et par paquets.

Les bits issus de l'entrelaceur 33 sont codés par des deuxièmes moyens de codage 32 dit de parité (dénommés aussi « codeur de parité » 32) lors d'une deuxième étape de codage E4 (dit codage de parité), selon un code de parité décrit dans la matrice de contrôle de parité V du code de parité.

Une deuxième étape de codage (dit codage interne) E6 est appliquée sur des bits issus du codeur de parité 32, pour former la séquence de bits codés S', selon le code décrit par une matrice de contrôle de parité G2 du code interne.

Avantageusement, l'étape de codage de parité E4 débute au bout d'une durée proportionnelle à un nombre prédéterminé $\Delta$ de bits, c'est-à-dire après l'entrelacement de $\Delta$ premiers bits. Ce nombre prédéterminé $\Delta$ est compris entre un premier nombre inférieur $\Delta i$ de bits et un premier nombre supérieur $\Delta s$ de bits correspondant au nombre total de bits devant être traités lors de l'étape d'entrelacement E3. Ainsi, l'étape de codage de parité E4 s'effectue en parallèle de l'étape d'entrelacement E3 et avec un décalage de $\Delta$ bits.

L'étape d'entrelacement E3 débute et s'effectue en parallèle de l'étape de codage externe E1 avec un décalage d'au moins un bit ($\Delta' - \Delta \geq 1$). De la même manière, l'étape de codage interne E6 débute et s'effectue en parallèle de l'étape de codage de parité E4 avec un décalage d'au moins un bit.

Selon un mode de réalisation préféré, le code considéré est un code de type LDPC (Low Density Parity Check) construit à partir d'une matrice de contrôle de parité H dont la forme est la suivante :

$$H = \begin{bmatrix} G1 & I & 0 \\ 0 & V & G2 \end{bmatrix} \quad \textbf{Eq. 2}$$

où,

- G1 est une matrice de contrôle de parité du code externe associée au codeur externe 30 (voir Figure 6);
- V est une matrice de contrôle de parité d'un code comprenant le code de parité et la fonction d'entrelacement; et

- G2 est la matrice de contrôle de parité du code interne associée au codeur interne 34 (voir Figure 6).

Le code externe est défini à partir de la matrice G1 qui est une matrice carrée de taille K × K, de la forme suivante :

$$G1 = \begin{bmatrix} I & & & Ip \\ I & I & & \\ & \ddots & \ddots & \\ & & I & I \end{bmatrix} \textbf{Eq. 3}$$

où I est une matrice identité de taille z × z et Ip est une matrice identité de taille z × z permutée circulairement de p positions vers la droite ou vers la gauche.

Optionnellement, il est possible de paralléliser l'étape de codage/décodage externe en fixant la valeur du nombre « p », de sorte que le code externe soit composé d'une pluralité de codes indépendants, permettant ainsi d'augmenter la rapidité d'encodage/décodage (au niveau du codage/décodage externe).

Dans cet exemple, le code externe est composé de « z » codes indépendants, dans le cas où p=0. Sinon, (c'est-à-dire dans le cas où p≠0), le code externe est composé de « z/b » codes indépendants, dans le cas où b est le plus petit entier non nul positif tel que : (b.p) modulo z = 0. **(Eq. 4)**

Par exemple, le code externe peut être composé d'une pluralité de codes convolutifs circulaires indépendants fonctionnant en parallèle et permettant ainsi d'augmenter le débit d'encodage.

$$G2 = \begin{bmatrix} I & & & Ie \\ I & I & & \\ & \ddots & \ddots & \\ & & I & I \end{bmatrix} \textbf{Eq. 5}$$

où I est une matrice identité de taille z × z, Ie est une matrice identité de taille z × z permutée non circulairement de « e » positions vers la droite ou vers la gauche.

Optionnellement, de même que pour l'étape de codage externe, il est possible de paralléliser l'étape de codage interne en fixant la valeur du nombre « e », de sorte que le code interne soit composé d'une pluralité de codes indépendants, permettant ainsi d'augmenter la rapidité d'encodage au niveau du codage interne.

Dans cet exemple, le code interne est composé de « z » codes indépendants dans le cas où e=0. Sinon, c'est-à-dire si e≠0, le code externe est composé d'un nombre de codes indépendants égal au nombre « e ».

Par exemple, le code interne peut être composé d'une pluralité de codes convolutifs circulaires récursifs indépendants fonctionnant en parallèle, permettant ainsi d'augmenter le débit d'encodage.

La matrice V est une matrice de taille M × K, de forme quasi-cyclique, comprenant une pluralité de matrices nulles et/ou de matrices identités permutées circulairement, la matrice V étant définie par la relation suivante :

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix} \quad \text{Eq. 6}$$

où,

- $m_1$ est un nombre entier strictement positif tel que K = $m_1$ × z (Eq. 7)
- $m_2$ est un nombre entier strictement positif tel que M = m2 × z **(Eq. 8)**
- I[c(i,j)] est soit une matrice nulle de taille z × z, soit une matrice identité permutée circulairement de taille z × z. Si c(i,j)<0, alors I[c(i,j)] est une matrice nulle. Sinon, I[c(i,j)] est une matrice identité permutée circulairement de c(i,j)

positions vers la droite ou vers la gauche

La forme de la matrice V telle que décrite ci-dessus comprend un code de parité et un double entrelacement par bits et par paquets selon l'invention.

Les figures 5A et 5B représentent respectivement un entrelacement par bits selon une première fonction $\pi$ et un entrelacement par paquets selon une seconde fonction $\lambda$.

Conformément à la figure 5A, les bits en sortie du codeur externe appartenant à un premier bloc de bits $B_1$ sont entrelacés selon la première fonction $\pi$ d'entrelacement par bits, pour former un deuxième bloc de bits entrelacés $B_2$.

Cette première fonction d'entrelacement $\pi$ associe à tout bit d'indice « i » appartenant au premier bloc de bits $B_1$, le bit d'indice $\pi(i)$ du bloc de bits entrelacés $B_2$, de telle sorte que l'entrelacement des k premiers bits du premier bloc de bits $B_1$ fournisse au moins les m premiers bits du deuxième bloc de bits entrelacés $B_2$. Ainsi, dans cet exemple, le prochain bit d'indice k+1 du premier bloc de bits $B_1$ devant être traité, sera positionné à la position d'indice $\pi(k+1)$ dans le deuxième bloc de bits entrelacés $B_2$, de sorte que $\pi(k+1)>m$.

Ainsi, dans le cas où le codage de parité s'effectue par blocs de J=m bits, cette fonction d'entrelacement permet de commencer le codage des J premiers bits issus des moyens d'entrelacement 33, sans avoir à attendre la fin de l'étape d'entrelacement E3. Contrairement à l'art antérieur précité, il n'est pas nécessaire d'attendre que la totalité des bits en sortie du codeur externe aient été entrelacés par les moyens d'entrelacement 33, pour pouvoir commencer l'étape de codage de parité E4.

Conformément à la figure 5B, les bits appartenant au premier bloc $B_1$ de bits en sortie du codeur externe 30 sont entrelacés selon une seconde fonction $\lambda$ d'entrelacement par paquets. Cette fonction $\lambda$ permet d'associer un premier ensemble de paquets ($P_1$, $P_2$, $P_3$, $P_4$, $P_5$) de $m_1$ bits appartenant au premier bloc $B_1$ de bits, à un second ensemble de paquets ($P_{10}$, $P_{20}$, $P_{30}$, $P_{40}$, $P_{50}$, $P_{60}$) de J bits entrelacés, de sorte que les bits appartenant à un même paquet $P_{30}$ de J bits entrelacés proviennent tous de paquets distincts appartenant au premier ensemble de paquets de $m_1$ bits ($P_1$, $P_2$, $P_3$, $P_4$, $P_5$). Dans l'exemple de la figure 5B, le paquet $P_{30}$ est composé de cinq bits ($b_1$, $b_2$, $b_3$, $b_4$, $b_5$) provenant respectivement des cinq paquets ($P_1$, $P_2$, $P_3$, $P_4$, $P_5$).

Dans le mode de réalisation préféré, la forme de la matrice V telle que décrite ci-dessus, permet de réaliser un double entrelacement par bits et par paquets respectivement selon la première fonction $\pi$ et la seconde fonction $\lambda$. Ainsi, à tout bit d'indice « $\pi(i)$ » appartenant au $l^{ème}$ paquet de J bits entrelacé est associé le $(i)^{ème}$ bit appartenant au $\lambda^{-1}(i,l)^{ème}$ paquet de $m_1$ bits.

Dans le procédé d'encodage (respectivement décodage) selon l'invention, la parallélisation de l'étape de codage (respectivement décodage) de parité et de l'étape de codage (respectivement décodage) externe est paramétrée par une métrique prédéterminée $\Delta$, correspondant à un nombre prédéterminé de bits.

La valeur de ce nombre $\Delta$ est calculée à partir des coefficients c(i,j) strictement positifs de la matrice V, de la manière suivante.

Soit $\Phi \equiv \{c_i\}$ l'ensemble des c(i,j) positifs et non nuls de la matrice V, rangés dans l'ordre croissant. Définissons une fonction « d » permettant de calculer la distance entre deux points x et y avec $x \geq y$, définie par d(x,y) = (x-y). La valeur de ce nombre $\Delta$ est alors calculée par la relation suivante :

$$\Delta = Max\left(\Delta_1,\, c_0 + z - c_{card(\Phi)-1}\right) \quad \text{Eq. 9}$$

où

card($\Phi$) représente le nombre d'éléments de l'ensemble $\Phi$ ;

$c_0$ est le plus petit coefficient c(i,j) positif et non nul de la matrice V de contrôle de parité ;

z est la dimension des sous-matrices identités contenues dans la matrice V de contrôle de parité ; et

$\Delta_1$ est la plus grande distance entre deux éléments adjacents quelconques ($c_i$ et $c_{i+1}$) appartenant à l'ensemble $\Phi$, cette distance étant définie par la relation suivante :

$$\Delta_1 = Max\left(\left\{d(c_{i+1}, c_i)\right\}_{i \in [0, card(\phi)-1]}\right) \quad \text{Eq. 10.}$$

La figure 6 illustre un mode de réalisation d'un dispositif d'encodage 100 selon l'invention, comprenant un premier codeur externe 30 (premiers moyens de codage), un codeur de parité 32 (deuxièmes moyens de codage) comprenant un entrelaceur 33 (moyens d'entrelacement), un codeur interne 34 (troisièmes moyens de codage), une première mémoire 36 placée entre le codeur externe 30 et le codeur de parité 32, et une seconde mémoire 38 placée entre le codeur de parité 32 et le codeur interne 34.

On notera que dans un autre mode de réalisation, l'entrelaceur 33 et le codeur de parité 32 peuvent être disjoints.

La première mémoire 36 comporte un premier ensemble de « z » premiers bancs de mémoire ($ME_1$ à $ME_z$), chacun de ces premiers bancs de mémoire ayant une capacité de stockage de $m_1$ bits.

La seconde mémoire 38 comporte au moins deux deuxièmes bancs de mémoire ($MI_1$ et $MI_2$), chacun de ces deuxièmes bancs de mémoire ayant une capacité de stockage de $m_2$ bits.

Un bloc de bits d'entrée B0 est encodé par le dispositif d'encodage 100 selon l'invention, pour former une séquence de bits codés S.

Le bloc de bits d'entrée B0 commence à être codé par le codeur externe 30, de manière à générer des premiers bits en sortie du codeur externe 30, ces premiers bits étant directement mémorisés dans les premiers bancs mémoires ($ME_1$ à $ME_z$) de la mémoire 36, dans l'ordre naturel et par paquets de $m_1$ bits.

Après un temps proportionnel au nombre prédéterminé Δ, le codeur de parité 32 lit un bit dans chaque banc de mémoire d'un sous-ensemble du premier ensemble de bancs de mémoire ($ME_1$ à $ME_z$) et les additionne ces bits selon une opération d'addition modulo-2 suivant des lois de parité décrites dans la matrice V (chaque ligne de la matrice V définissant une équation de parité).

Le codeur de parité 32 peut traiter, par exemple, $m_2$ équations de parité contenues dans $m_2$ lignes dans la matrice V, de manière à générer $m_2$ bits en sortie du codeur de parité 32. Ces $m_2$ bits sont directement stockés dans un banc mémoire $MI_1$ du second ensemble de bancs mémoires ($MI_1$ et $MI_2$) de la mémoire 38.

Dès la fin de l'écriture de $m_2$ bits dans un banc mémoire ($MI_1$, $MI_2$) en sortie du codeur de parité 32, le codeur interne 34 lit ces $m_2$ bits qu'il peut commencer à coder de manière quasi-instantanée selon le code interne contenu dans la matrice de contrôle de parité G2 du code interne.

Etant donné que l'opération de codage interne s'effectue sur $m_2$ bits et juste après l'écriture de $m_2$ bits dans un deuxième banc de mémoire ($MI_1$ dans cet exemple), il suffit que la seconde mémoire 38 contienne uniquement deux blocs mémoires ($MI_1$, $MI_2$) pour permettre une utilisation optimale des ressources matérielles, chacun de ces deux bancs de mémoire fonctionnant alternativement en écriture et en lecture.

En pratique, il suffit que le codeur de parité ait traité un bit pour permettre au codeur interne de commencer sa tâche en parallèle du codeur de parité.

La figure 7 illustre, de manière très schématique, l'ordonnancement dans le temps (en abscisse) des différentes étapes (en ordonnée) constitutives d'un procédé de décodage selon un mode de réalisation particulier.

Ce procédé de décodage permet de décoder un signal de réception numérisé comprenant une séquence de données formée d'une première partie D correspondant à des informations à transmettre et d'une seconde partie C comportant de données de redondance.

Selon ce procédé, une première étape de décodage (dit décodage externe) E100 est appliquée sur des données de la première partie D. Une étape d'entrelacement E300 réalisée par des moyens d'entrelacement 43 (dénommés aussi entrelaceur 43) permet d'entrelacer des données issues de la première étape de décodage E100 (étape de décodage externe). Une deuxième étape de décodage dit de parité E400 (étape de décodage de parité) est appliquée sur des données issues de l'entrelaceur 43. Une troisième étape de décodage (dite étape de décodage interne) E600 est appliquée sur des données issues de l'étape de décodage de parité E400.

Avantageusement, l'étape de décodage de parité E400 débute après l'entrelacement d'un nombre prédéterminé Δ de données. Ce nombre prédéterminé Δ de données est compris entre un premier nombre inférieur Δi de données dépendant d'au moins un paramètre de l'étape d'entrelacement E300, et un premier nombre supérieur Δs de données correspondant au nombre total de données devant être traitées lors de l'étape d'entrelacement E300.

La figure 8 illustre un mode de réalisation d'un dispositif de décodage 200 selon l'invention, permettant de décoder un signal de réception numérisé comprenant une séquence de données formée d'une première partie D correspondant à des informations à transmettre et d'une seconde partie C comportant des données de redondance.

Le dispositif de décodage 200 selon l'invention comprend un décodeur externe 40 (ou premiers moyens de décodage 40), un décodeur de parité 42 (ou deuxièmes moyens de décodage dit de parité 42) comprenant un entrelaceur 43 (ou moyens d'entrelacement 43), un décodeur interne 44 (ou deuxièmes moyens de décodage 44), un premier module de mémoire 46 placé en entrée du décodeur externe 40 et du décodeur interne 44, un deuxième module de mémoire 48 placé entre le décodeur externe 40 et le décodeur de parité 42, un troisième module de mémoire 50 placé entre le codeur de parité 42 et le codeur interne 44.

On notera que dans un autre mode de réalisation l'entrelaceur 43 et le décodeur de parité 42 peuvent être disjoints.

L'entrelaceur 43 est adapté de sorte que le décodeur de parité 42 débute l'étape de décodage de parité E400 après l'entrelacement d'un nombre prédéterminé Δ de données. Ce nombre prédéterminé Δ de données est compris entre un premier nombre inférieur Δi de données dépendant d'au moins un paramètre de l'entrelaceur 43, et un premier nombre supérieur Δs de données correspondant au nombre total de données devant être traitées par l'entrelaceur 43.

Le premier module de mémoire 46, destiné à mémoriser un signal numérisé de réception comportant « $m_1 \times z$ » valeurs souples, comprend « z » premiers bancs de mémoire ($M_1$ à $M_z$), chacun de ces bancs de mémoire ayant une

capacité de stockage de $m_1$ bits.

Le deuxième module de mémoire 48, destiné à mémoriser des données transitant entre le décodeur externe 40 et le décodeur de parité 42, comprend « z » deuxièmes bancs mémoires ($ME_1$ à $ME_z$) ayant chacun une capacité de stockage de $m_1$ bits.

Le troisième module de mémoire 50, destiné à mémoriser des données transitant entre le décodeur de parité 42 et le décodeur interne 44, comprend « z » deuxièmes bancs mémoires ($MI_1$ à $MI_z$) ayant chacun une capacité de stockage de $m_2$ bits.

La décomposition des mémoires 46, 48, 50 en une pluralité de bancs mémoires respectivement ($M_1$ à $M_z$), ($ME_1$ à $ME_z$), ($MI_1$,à $MI_z$) permet de minimiser, voire de supprimer les accès simultanés à une même mémoire.

Le décodage d'une trame de N valeurs souples se déroule selon un procédé itératif. On notera que le décodage souple du code interne et du code externe peut être réalisé en utilisant des techniques classiques de décodage de codes convolutifs à sortie souple comme l'algorithme BCJR (Bahl-Cocke-Jelinek-Raviv), l'algorithme FBA (Forward Backward Algorithm) ou encore l'algorithme SOVA (Soft Output Viterbi Algorithm), tels que décrit par L.R. Bahl et al. dans le document intitulé « Optimal Decoding of Linear Codes for Minimizing Symbol Error Rate » (IEEE Transactions on Information Theory, Volume IT-20, March 1974, pp. 248-287.)

L'étape d'initialisation de ce procédé consiste à mémoriser, dans l'ordre naturel et par paquets de $m_1$ valeurs souples, les N données contenues dans un signal de réception (tel que $N = m_1 \times z$), dans les « z » premiers bancs de mémoire ($M_1$ à $M_z$) du premier module de mémoire 46.

Autrement dit, les $m_1$ premières valeurs souples du signal reçu sont mémorisées dans le premier banc de mémoire $M_1$, les $m_1$ valeurs souples suivantes sont mémorisées dans le banc de mémoire suivant $M_2$ et ainsi de suite.

Pour chaque itération, le procédé comporte les étapes suivantes.

Le décodeur externe 40 réalise un décodage sur une fenêtre d'indice j comprenant $m_1$ données (ou $m_1$ valeurs souples) contenues dans le banc de mémoire $M_j$ appartenant au premier module de mémoire 46, de manière à générer des premières données extrinsèques qui sont mémorisées dans le banc de mémoire $ME_j$ appartenant au deuxième module de mémoire 48.

Après le décodage d'un nombre $\Delta$ de fenêtres, le décodeur de parité 42 peut fonctionner en parallèle et sans conflit avec le décodeur externe 40.

Les équations de parité définies dans la matrice V sont résolues en série et par groupe de $m_2$ équations, à partir des variables ou données fournies en sortie du codeur externe. Les valeurs de chacune de ces variables utilisées dans les $m_2$ équations de parité de la matrice V lors du décodage d'une fenêtre sont lues dans des bancs de mémoires ($ME_1$ à $ME_z$) différents. Pour chaque fenêtre d'indice i, les $m_2$ équations du $i^{ème}$ groupe de $m_2$ équations sont résolues dans l'ordre suivant : i, i+z, i+2xz, ..., $i+m_2 \times z$, (avec i compris entre 1 et z).

Le résultat du décodage du $i^{ème}$ groupe de $m_2$ équations est stocké dans le $i^{ème}$ banc de mémoire $MI_i$ appartenant au troisième module de mémoire 50. Par exemple, les $m_2$ données résultant de la résolution du $2^{ème}$ groupe de $m_2$ équations de parité, sont mémorisées dans le $2^{ème}$ banc de mémoire $MI_2$.

Directement après la résolution du premier groupe de $m_2$ équations réalisé sur une fenêtre d'indice i par le codeur de parité, le décodeur interne peut commencer sa tâche de décodage sur cette fenêtre. Les informations extrinsèques résultant du décodage de la fenêtre d'indice i sont stockées dans le banc mémoire $MI_i$ appartenant au troisième module de mémoire 50.

Suite au décodage de $\Delta$ fenêtres par le décodeur interne, les variables intervenant dans les équations de parité définies dans la matrice V sont mises à jour.

Pour éviter tout conflit d'accès à un même banc de mémoire lors de l'étape de décodage de parité, il est nécessaire qu'une variable n'intervienne pas plus d'une seule fois dans un groupe de $m_2$ équations de parité. Cette règle se traduit par la condition que pour une même colonne de la matrice V, tous les coefficients c(i,j) positifs sont distincts.

L'invention vise aussi un programme d'ordinateur téléchargeable depuis un réseau de communication comprenant des instructions de codes de programme pour l'exécution des étapes du procédé d'encodage et/ou du procédé de décodage selon l'invention lorsqu'il est exécuté sur un ordinateur. Ce programme d'ordinateur peut être stocké sur un support lisible par ordinateur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique,

qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

On notera que le dispositif d'encodage peut être mis en oeuvre par un système informatique F, tel que représenté sur la figure 9, comportant de manière classique une unité centrale de traitement 60 commandant par des signaux B une mémoire 62, une unité d'entrée 64 et une unité de sortie 66. Tous les éléments sont raccordés entre eux par des bus de données 68.

De plus, ce système informatique peut être utilisé pour exécuter un programme d'ordinateur comportant des instructions pour la mise en oeuvre du procédé d'encodage selon l'invention.

On notera que le dispositif de décodage peut être aussi mis en oeuvre par un système informatique comme celui de la figure 9.

De plus, ce système informatique peut être utilisé pour exécuter un programme d'ordinateur comportant des instructions pour la mise en oeuvre du procédé de décodage selon l'invention.

## Revendications

1. Procédé d'encodage d'une séquence de bits d'entrée (S0) en une séquence de bits codés (S), ledit procédé comprenant :

   - une première étape (E1) de codage appliquée sur les bits de la séquence de bits d'entrée (S0), selon un premier code ;
   - une étape d'entrelacement (E3) destinée à entrelacer, par des moyens d'entrelacement (33), les bits issus dudit premier code;
   - une deuxième étape (E4) de codage dit de parité, appliquée sur les bits issus desdits moyens d'entrelacement (33), selon un deuxième code, pour générer ladite séquence de bits codés (S);

   ledit procédé étant **caractérisé en ce que** ladite deuxième étape de codage (E4) de parité débute après l'entrelacement d'un nombre $\Delta$ prédéterminé de bits sans attendre la fin de l'étape d'entrelacement (E3), ledit nombre $\Delta$ prédéterminé de bits étant compris entre un premier nombre inférieur $\Delta i$ de bits dépendant d'au moins un paramètre de ladite étape d'entrelacement (E3), et un premier nombre supérieur $\Delta s$ de bits correspondant au nombre total de bits devant être traités lors de ladite étape d'entrelacement (E3).

2. Procédé d'encodage selon la revendication 1, **caractérisé en ce que** ladite deuxième étape de codage (E4) de parité débute après l'encodage d'un nombre prédéterminé $\Delta'$ de bits selon la première étape (E1) de codage, ledit nombre prédéterminé $\Delta'$ de bits étant compris entre un second nombre inférieur $\Delta i'$ de bits dépendant d'au moins un paramètre de ladite étape d'entrelacement (E3), et un second nombre supérieur $\Delta s'$ de bits correspondant au nombre total de bits devant être traités lors de ladite première étape de codage (E1).

3. Procédé d'encodage selon l'une quelconque des revendications précédentes, **caractérisé en ce que** ladite étape d'entrelacement (E3) est effectuée conjointement avec ladite deuxième étape de codage de parité (E4).

4. Procédé d'encodage selon l'une quelconque des revendications 1 à 4, **caractérisé en ce que** ladite étape d'entrelacement (E3) comporte une première fonction $\pi$ d'entrelacement par bits associant au $i^{ème}$ bit issu dudit premier code, le $\pi(i)^{ème}$ bit d'une séquence de bits entrelacés (B2), de sorte que l'entrelacement des k premiers bits fournisse au moins les m premiers bits de ladite séquence de bits entrelacés (B2).

5. Procédé d'encodage selon l'une quelconque des revendications 3 et 4, **caractérisé en ce que** ladite étape d'entrelacement (E3) et ladite deuxième étape (E4) de codage de parité sont réalisées au moyen d'une matrice V de contrôle de parité quasi-cyclique comprenant une pluralité de sous-matrices identités, de la forme suivante :

$$V=\begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

telle que pour tout i compris entre 1 et $m_1$ et pour tout j compris entre 1 et $m_2$, si le coefficient c(i,j) est strictement négatif alors la sous-matrice $I[c(i,j)]$ est une matrice nulle, sinon ladite sous-matrice $I[c(i,j)]$ est une matrice identité permutée circulairement de c(i,j) positions.

6. Procédé d'encodage selon l'une quelconque des revendications 3 à 5, **caractérisé en ce que** ladite étape d'entrelacement (E3) comporte une seconde fonction λ d'entrelacement permettant d'associer un premier ensemble de paquets de $m_1$ bits (P1, P2, P3, P4, P5) issus du premier code à un second ensemble de paquets (P10, P20, P30, P40, P50, P60) de J bits de ladite séquence de bits entrelacés (B2), de sorte que les bits appartenant à un même paquet (P30) de J bits de ladite séquence de bits entrelacés (B2) proviennent de paquets distincts dudit premier ensemble de paquets (P1, P2, P3, P4, P5) de $m_1$ bits.

7. Procédé d'encodage selon l'une quelconque des revendications précédentes, **caractérisé en ce qu'**il comporte une troisième étape (E6) de codage, selon un troisième code, appliquée sur des bits issus de ladite deuxième étape (E4) de codage de parité, de sorte que ladite troisième étape (E6) de codage débute à partir du codage d'au moins un bit issu de ladite deuxième étape (E4) -de décodage de parité.

8. Procédé de décodage d'un signal de réception numérisé comprenant une séquence de données formée d'une première partie D correspondant aux informations à transmettre et d'une seconde partie C comportant de données de redondance, ledit procédé étant **caractérisé en ce qu'**il comprend :

- une première étape (E100) de décodage appliquée sur des données de ladite première partie D ;
- une étape d'entrelacement (E300) destinée à entrelacer par des moyens d'entrelacement (43) des données issues de ladite première étape (E100) de décodage ;
- une deuxième étape (E400) de décodage dit de parité, appliquée sur des données issues desdits moyens d'entrelacement (43);

ledit procédé étant **caractérisé en ce que** ladite deuxième étape (E400) de décodage de parité débute après l'entrelacement d'un nombre prédéterminé Δ de données, sans attendre la fin de l'étape d'entrelacement (E300), ledit nombre prédéterminé Δ de données étant compris entre un premier nombre inférieur Δi de données dépendant d'au moins un paramètre de ladite étape d'entrelacement (E300), et un premier nombre supérieur Δs de données correspondant au nombre total de données devant être traitées lors de ladite étape d'entrelacement (E300).

9. Procédé de décodage selon la revendication 8, **caractérisé en ce que** ladite deuxième étape (E400) de décodage de parité débute après le décodage d'un nombre prédéterminé Δ' de données selon ladite première étape de décodage (E100), ledit nombre prédéterminé Δ' de données étant compris entre un second nombre inférieur Δi' de données dépendant d'au moins un paramètre de ladite étape d'entrelacement (E300), et un second nombre supérieur Δs' de données correspondant au nombre total de données devant être traitées lors de ladite première étape de décodage (E100).

10. Procédé de décodage selon la revendications 8 ou la revendication 9, **caractérisé en ce que** ladite étape d'entrelacement (E300) est effectuée conjointement avec ladite deuxième étape (E400) de décodage de parité.

11. Procédé de décodage selon la revendication 10, **caractérisé en ce que** ladite étape d'entrelacement (E300) et ladite deuxième étape de décodage (E400) sont réalisées au moyen d'une matrice V de contrôle de parité quasi-cyclique comprenant une pluralité de sous-matrices identités, de la forme suivante :

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

telle que pour tout i compris entre 1 et $m_1$ et pour tout j compris entre 1 et $m_2$, si le coefficient c(i,j) est strictement négatif alors la sous-matrice $I[c(i,j)]$ est une matrice nulle, sinon ladite sous-matrice $I[c(i,j)]$ est une matrice identité permutée circulairement de c(i,j) positions.

**12.** Dispositif d'encodage d'une séquence de bits d'entrée (S0) en une séquence de bits codés (S), ledit dispositif comprenant :

- des premiers moyens de codage (30) destinés à coder les bits de ladite séquence de bits d'entrée (S0), selon un premier code;
- des moyens d'entrelacement (33) destinés à entrelacer des bits issus desdits premiers moyens de codage (30) ;
- des deuxièmes moyens de codage (32) dit de parité, destinés à coder des bits issus desdits moyens d'entrelacement (33), selon un deuxième code, pour générer ladite séquence de bits codés (S);

ledit dispositif étant **caractérisé en ce que** lesdits moyens d'entrelacement (33) sont adaptés de sorte que lesdits deuxièmes moyens de codage de parité (32) débutent ladite séquence de bits codés (S) après l'entrelacement d'un nombre Δ prédéterminé de bits, sans attendre la fin de l'entrelacement, ledit nombre Δ prédéterminé de bits étant compris entre un premier nombre inférieur Δi de bits dépendant d'au moins un paramètre desdits moyens d'entrelacement (33), et un premier nombre supérieur Δs de bits correspondant au nombre total de bits devant être traités par lesdits moyens d'entrelacement (33).

**13.** Dispositif de décodage d'un signal de réception numérisé comprenant une séquence de données formée d'une première partie D correspondant à des informations à transmettre et d'une seconde partie C comportant des données de redondance, ledit dispositif comprenant :

- des premiers moyens de décodage (40) des données de ladite première partie D;
- des moyens d'entrelacement (43) destinés à entrelacer des bits issus desdits premiers moyens de décodage (40);
- des deuxièmes moyens de décodage (42) dit de parité destinés à décoder des bits issus desdits moyens d'entrelacement (43);

ledit dispositif étant **caractérisé en ce que** lesdits moyens d'entrelacement (43) sont adaptés de sorte que lesdits deuxièmes moyens de décodage de parité (42) débutent le décodage de parité après l'entrelacement d'un nombre prédéterminé Δ de données, sans atteindre la fin de l'entrelacement, ledit nombre prédéterminé Δ de données étant compris entre un premier nombre inférieur Δi de données dépendant d'au moins un paramètre desdits moyens d'entrelacement (43), et un premier nombre supérieur Δs de données correspondant au nombre total de données devant être traitées par lesdits moyens d'entrelacement (43).

**14.** Produit programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé d'encodage selon au moins l'une des revendications 1 à 7, lorsqu'il est exécuté sur un ordinateur.

**15.** Produit programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé de décodage selon au moins l'une des revendications 8 à 11, lorsqu'il est exécuté sur un ordinateur.

## Claims

1. Method of encoding a sequence of input bits (S0) as a sequence of coded bits (S), said method comprising:

- a first coding step (E1) applied to the bits of the sequence of input bits (SO), according to a first code;
- an interleaving step (E3) designed to interleave, by interleaving means (33), the bits deriving from said first code;
- a second so-called parity coding step (E4), applied to the bits deriving from said interleaving means (33), according to a second code, to generate said sequence of coded bits (S);

said method being **characterized in that** said second parity coding step (E4) begins after the interleaving of a predetermined number Δ of bits without waiting for the end of the interleaving step (E3), said predetermined number Δ of bits being between a first lower number Δi of bits dependent on at least one parameter of said interleaving step (E3), and a first upper number Δs of bits corresponding to the total number of bits that have to be processed in said interleaving step (E3).

2. Encoding method according to Claim 1, **characterized in that** said second parity coding step (E4) begins after the encoding of a predetermined number Δ' of bits according to the first coding step (E1), said predetermined number Δ' of bits being between a second lower number Δi' of bits dependent on at least one parameter of said interleaving step (E3), and a second upper number Δs' of bits corresponding to the total number of bits that have to be processed in said first coding step (E1).

3. Encoding method according to any one of the preceding claims, **characterized in that** said interleaving step (E3) is performed jointly with said second parity coding step (E4).

4. Encoding method according to any one of Claims 1 to 3, **characterized in that** said interleaving step (E3) includes a first bit-based interleaving function π associating with the $i^{th}$ bit deriving from said first code, the $n(i)^{th}$ bit of a sequence of interleaved bits (B2), so that the interleaving of the first k bits supplies at least the first m bits of said sequence of interleaved bits (B2).

5. Encoding method according to any one of Claims 3 and 4, **characterized in that** said interleaving step (E3) and said second parity coding step (E4) are performed by means of a quasi-cyclical parity checking matrix V comprising a plurality of identity submatrices, of the following form:

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

such that, for any i between 1 and $m_1$, and for any j between 1 and $m_2$, if the coefficient c(i,j) is strictly negative, then the submatrix I[c(i,j)] is a zero matrix, otherwise said submatrix I[c(i,j)] is a circularly permutated identity matrix of c(i,j) positions.

6. Encoding method according to any one of Claims 3 to 5, **characterized in that** said interleaving step (E3) includes a second interleaving function λ making it possible to associate a first set of packets of $m_1$ bits (P1, P2, P3, P4, P5) deriving from the first code with a second set of packets (P10, P20, P30, P40, P50, P60) of J bits of said sequence of interleaved bits (B2), so that the bits belonging to one and the same packet (P30) of J bits of said sequence of interleaved bits (B2) originate from separate packets of said first set of packets (P1, P2, P3, P4, P5) of $m_1$ bits.

7. Encoding method according to any one of the preceding claims, **characterized in that** it includes a third coding step (E6), according to a third code, applied to the bits deriving from said second parity coding step (E4), so that said third coding step (E6) begins from the coding of at least one bit deriving from said second parity coding step (E4).

**8.** Method of decoding a digitized reception signal comprising a sequence of data consisting of a first part D corresponding to the information to be transmitted and a second part C including redundancy data, said method being **characterized in that** it comprises:

- a first decoding step (E100) applied to data of said first part D;
- an interleaving step (E300) designed to interleave, by interleaving means (43), data deriving from said first decoding step (E100);
- a second so-called parity decoding step (E400), applied to data deriving from said interleaving means (43) ;

said method being **characterized in that** said second parity decoding step (E400) begins after the interleaving of a predetermined number Δ of data, without waiting for the end of the interleaving step (E300), said predetermined number Δ of data being between a first lower number Δi of data dependent on at least one parameter of said interleaving step (E300), and a first upper number Δs of data corresponding to the total number of data that have to be processed in said interleaving step (E300).

**9.** Decoding method according to Claim 8, **characterized in that** said second parity decoding step (E400) begins after the decoding of a predetermined number Δ' of data according to said first decoding step (E100), said predetermined number Δ' of data being between a second lower number Δ' of data dependent on at least one parameter of said interleaving step (E300), and a second upper number Δs' of data corresponding to the total number of data that have to be processed in said first decoding step (E100).

**10.** Decoding method according to Claim 8 or Claim 9, **characterized in that** said interleaving step (E300) is performed jointly with said second parity decoding step (E400).

**11.** Decoding method according to Claim 10, **characterized in that** said interleaving step (E300) and said second decoding step (E400) are performed by means of a quasi-cyclical parity checking matrix V comprising a plurality of identity submatrices, of the following form:

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

such that, for any i between 1 and $m_1$ and for any j between 1 and $m_2$, if the coefficient c(i,j) is strictly negative, then the submatrix I[c(i,j)] is a zero matrix, otherwise said submatrix I[c(i,j)] is a circularly permutated identity matrix of c (i,j) positions.

**12.** Device for encoding a sequence of input bits (S0) as a sequence of coded bits (S), said device comprising:

- first coding means (30) designed to code the bits of said sequence of input bits (SO), according to a first code;
- interleaving means (33) designed to interleave bits deriving from said first coding means (30);
- second so-called parity coding means (32), designed to code bits deriving from said interleaving means (33), according to a second code, to generate said sequence of coded bits (S);

said device being **characterized in that** said interleaving means (33) are adapted so that said second parity coding means (32) begin said sequence of coded bits (S) after the interleaving of a predetermined number Δ of bits, without waiting for the end of the interleaving, said predetermined number Δ of bits being between a first lower number Δi of bits dependent on at least one parameter of said interleaving means (33), and a first upper number Δs of bits corresponding to the total number of bits that have to be processed by said interleaving means (33).

**13.** Device for decoding a digitized reception signal comprising a sequence of data consisting of a first part D corresponding to information to be transmitted and a second part C including redundancy data, said device comprising:

- first means (40) of decoding the data of said first part D;
- interleaving means (43) designed to interleave bits deriving from said first decoding means (40);
- second so-called parity decoding means (42) designed to decode bits deriving from said interleaving means (43);

said device being **characterized in that** said interleaving means (43) are adapted so that said second parity decoding means (42) begin the parity decoding after the interleaving of a predetermined number Δ of data, without waiting for the end of the interleaving, said predetermined number Δ of data being between a first lower number Δt of data dependent on at least one parameter of said interleaving means (43), and a first upper number Δs of data corresponding to the total number of data that have to be processed by said interleaving means (43).

**14.** Computer program product that can be downloaded from a communication network and/or stored on a medium that can be read by computer and/or executed by a microprocessor, **characterized in that** it comprises program code instructions for the execution of the steps of the encoding method according to at least one of Claims 1 to 7, when executed on a computer.

**15.** Computer program product that can be downloaded from a communication network and/or stored on a medium that can be read by computer and/or executed by a microprocessor, **characterized in that** it comprises program code instructions for the execution of the steps of the decoding method according to at least one of Claims 8 to 11, when executed on a computer.

## Patentansprüche

**1.** Verfahren zum Codieren einer Folge von Eingangsbits (S0) in eine Folge von codierten Bits (S), wobei das Verfahren aufweist:

- einen ersten Codierschritt (E1), der an die Bits der Folge von Eingangsbits (S0) gemäß einem ersten Code angewendet wird;
- einen Verschachtelungsschritt (E3), der dazu bestimmt ist, durch Verschachtelungseinrichtungen (33) die vom ersten Code stammenden Bits zu verschachteln;
- einen zweiten so genannten Paritätscodierschritt (E4), der an die von den Verschachtelungseinrichtungen (33) stammenden Bits gemäß einem zweiten Code angewendet wird, um die Folge von codierten Bits (S) zu erzeugen;

wobei das Verfahren **dadurch gekennzeichnet ist, dass** der zweite Paritätscodierschritt (E4) nach der Verschachtelung einer vorbestimmten Anzahl Δ von Bits beginnt, ohne das Ende des Verschachtelungsschritts (E3) abzuwarten, wobei die vorbestimmte Anzahl Δ von Bits zwischen einer ersten niedrigeren Anzahl Δi von Bits, die von mindestens einem Parameter des Verschachtelungsschritts (E3) abhängt, und einer ersten höheren Anzahl Δs von Bits liegt, die der Gesamtanzahl von Bits entspricht, die während des Verschachtelungsschritts (E3) verarbeitet werden sollen.

**2.** Codierverfahren nach Anspruch 1, **dadurch gekennzeichnet, dass** der zweite Paritätscodierschritt (E4) nach der Codierung einer vorbestimmten Anzahl Δ' von Bits gemäß dem ersten Codierschritt (E1) beginnt, wobei die vorbestimmte Anzahl Δ' von Bits zwischen einer zweiten niedrigeren Anzahl Δi' von Bits, die von mindestens einem Parameter des Verschachtelungsschritts (E3) abhängt, und einer zweiten höheren Anzahl Δs' von Bits liegt, die der Gesamtzahl von Bits entspricht, die während des ersten Codierschritts (E1) verarbeitet werden sollen.

**3.** Codierverfahren nach einem der vorhergehenden Ansprüche, **dadurch gekennzeichnet, dass** der Verschachtelungsschritt (E3) zusammen mit dem zweiten Paritätscodierschritt (E4) durchgeführt wird.

**4.** Codierverfahren nach einem der Ansprüche 1 bis 3, **dadurch gekennzeichnet, dass** der Verschachtelungsschritt (E3) eine erste Funktion π der bitweisen Verschachtelung aufweist, die dem i-ten vom ersten Code stammenden Bit das π(i)-te Bit einer Folge von verschachtelten Bits (B2) zuordnet, so dass die Verschachtelung der k ersten Bits mindestens die m ersten Bits der Folge von verschachtelten Bits (B2) liefert.

**5.** Codierverfahren nach einem der Ansprüche 3 und 4, **dadurch gekennzeichnet, dass** der Verschachtelungsschritt (E3) und der zweite Paritätscodierschritt (E4) mittels einer mehrere Identitäts-Untermatrizen enthaltenden Matrix V der praktisch zyklischen Paritätsüberwachung der folgenden Form durchgeführt werden:

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

derart, dass für jedes zwischen 1 und $m_1$ enthaltene i und für jedes zwischen 1 und $m_2$ enthaltene j, wenn der Koeffizient c(i,j) strikt negativ ist, die Untermatrix I[c(i,j)] eine Matrix Null ist, ansonsten ist die Untermatrix I[c(i,j)] eine zirkulär permutierte Identitätsmatrix mit c(i,j) Positionen.

**6.** Codierverfahren nach einem der Ansprüche 3 bis 5, **dadurch gekennzeichnet, dass** der Verschachtelungsschritt (E3) eine zweite Verschachtelungsfunktion $\lambda$ aufweist, die es ermöglicht, eine erste Einheit von Paketen (P1, P2, P3, P4, P5) von $m_1$ Bits, die vom ersten Code stammen, einer zweiten Einheit von Paketen (P10, P20, P30, P40, P50, P60) von J Bits der Folge von verschachtelten Bits (B2) derart zuzuordnen, dass die zu einem gleichen Paket (P30) von J Bits der Folge von verschachtelten Bits (B2) gehörenden Bits von verschiedenen Paketen der ersten Einheit von Paketen (P1, P2, P3, P4, P5) von $m_1$ Bits stammen.

**7.** Codierverfahren nach einem der vorhergehenden Ansprüche, **dadurch gekennzeichnet, dass** es einen dritten Codierschritt (E6) gemäß einem dritten Code aufweist, der an Bits angewendet wird, die vom zweiten Paritätscodierschritt (E4) stammen, so dass der dritte Codierschritt (E6) ausgehend von der Codierung mindestens eines Bits beginnt, das vom zweiten Paritätscodierschritt (E4) stammt.

**8.** Verfahren zum Decodieren eines digitalisierten Empfangssignals, das eine Folge von Daten aufweist, die von einem ersten Teil D, der den zu übertragenden Informationen entspricht, und von einem zweiten Teil C gebildet wird, der Redundanzdaten enthält, wobei das Verfahren **dadurch gekennzeichnet ist, dass** es aufweist:

- einen ersten Decodierschritt (E100), der an Daten des ersten Teils D angewendet wird;
- einen Verschachtelungsschritt (E300), der dazu bestimmt ist, durch Verschachtelungseinrichtungen (43) Daten zu verschachteln, die vom ersten Decodierschritt (E100) stammen;
- einen zweiten so genannten Paritätsdecodierschritt (E400), der an Daten angewendet wird, die von den Verschachtelungseinrichtungen (43) stammen;

wobei das Verfahren **dadurch gekennzeichnet ist, dass** der zweite Paritätsdecodierschritt (E400) nach der Verschachtelung einer vorbestimmten Anzahl $\Delta$ von Daten beginnt, ohne das Ende des Verschachtelungsschritts (E300) abzuwarten, wobei die vorbestimmten Anzahl $\Delta$ von Daten zwischen einer ersten niedrigeren Anzahl $\Delta i$ von Daten, die von mindestens einem Parameter des Verschachtelungsschritts (E300) abhängt, und einer ersten höheren Anzahl $\Delta s$ von Daten liegt, die der Gesamtanzahl von Daten entspricht, die im Verschachtelungsschritt (E300) verarbeitet werden sollen.

**9.** Decodierverfahren nach Anspruch 8, **dadurch gekennzeichnet, dass** der zweite Paritätsdecodierschritt (E400) nach der Decodierung einer vorbestimmten Anzahl $\Delta'$ von Daten gemäß dem ersten Decodierschritt (E100) beginnt, wobei die vorbestimmte Anzahl A’ von Daten zwischen einer zweiten niedrigeren Anzahl $\Delta i'$ von Daten, die von mindestens einem Parameter des Verschachtelungsschritts (E300) abhängt, und einer zweiten höheren Anzahl $\Delta s'$ von Daten liegt, die der Gesamtanzahl von Daten entspricht, die im ersten Decodierschritt (E100) verarbeitet werden sollen.

**10.** Decodierverfahren nach Anspruch 8 oder Anspruch 9, **dadurch gekennzeichnet, dass** der Verschachtelungsschritt

(E300) zusammen mit dem zweiten Paritätsdecodierschritt (E400) durchgeführt wird.

**11.** Decodierverfahren nach Anspruch 10, **dadurch gekennzeichnet, dass** der Verschachtelungsschritt (E300) und der zweite Paritätsdecodierschritt (E400) mittels einer mehrere Identitäts-Untermatrizen aufweisenden Matrix V der praktisch zyklischen Paritätsüberwachung der folgenden Form durchgeführt werden:

$$V = \begin{pmatrix} I[c(1,1)] & \cdots & \cdots & \cdots & I[c(1,m_2)] \\ \vdots & \ddots & & & \vdots \\ \vdots & & I[c(i,j)] & & \vdots \\ \vdots & & & \ddots & \vdots \\ I[c(m_1,1)] & \cdots & \cdots & \cdots & I[c(m_1,m_2)] \end{pmatrix}$$

derart, dass für jedes zwischen 1 und $m_1$ enthaltene i und für jedes zwischen 1 und $m_2$ enthaltene j, wenn der Koeffizient c(i,j) strikt negativ ist, die Untermatrix I[c(i,j)] eine Matrix Null ist, ansonsten ist die Untermatrix I[c(i,j)] eine zirkulär permutierte Identitätsmatrix mit c(i,j) Positionen.

**12.** Vorrichtung zum Codieren einer Folge von Eingangsbits (S0) in eine Folge von codierten Bits (S), wobei die Vorrichtung aufweist:

- erste Codiereinrichtungen (30), die dazu bestimmt sind, die Bits der Folge von Eingangsbits (S0) gemäß einem ersten Code zu codieren;
- Verschachtelungseinrichtungen (33), die dazu bestimmt sind, Bits zu verschachteln, die von den ersten Codiereinrichtungen (30) stammen;
- erste so genannte Paritätscodiereinrichtungen (32), die dazu bestimmt sind, von den Verschachtelungseinrichtungen (33) stammende Bits gemäß einem zweiten Code zu codieren, um die Folge von codierten Bits (S) zu erzeugen;

wobei die Vorrichtung **dadurch gekennzeichnet ist, dass** die Verschachtelungseinrichtungen (33) so angepasst sind, dass die zweiten Paritätscodiereinrichtungen (32) die Folge von codierten Bits (S) nach der Verschachtelung einer vorbestimmten Anzahl Δ von Bits beginnen, ohne das Ende der Verschachtelung abzuwarten, wobei die vorbestimmte Anzahl Δ von Bits zwischen einer ersten niedrigeren Anzahl Δi, die von mindestens einem Parameter der Verschachtelungseinrichtungen (33) abhängt, und einer ersten höheren Anzahl Δs von Bits liegt, die der Gesamtanzahl von Bits entspricht, die von den Verschachtelungseinrichtungen (33) verarbeitet werden sollen.

**13.** Vorrichtung zum Decodieren eines digitalisierten Empfangssignals, das eine Folge von Daten aufweist, die von einem ersten Teil D entsprechend zu übertragenden Informationen und von einem zweiten Teil C gebildet wird, der Redundanzdaten enthält, wobei die Vorrichtung aufweist:

- erste Decodiereinrichtungen (40) der Daten des ersten Teils D;
- Verschachtelungseinrichtungen (43), die dazu bestimmt sind, von den ersten Decodiereinrichtungen (40) stammende Bits zu verschachteln;
- zweite so genannte Paritätsdecodiereinrichtungen (42), die dazu bestimmt sind, von den Verschachtelungseinrichtungen (43) stammende Bits zu decodieren;

wobei die Vorrichtung **dadurch gekennzeichnet ist, dass** die Verschachtelungseinrichtungen (43) so angepasst sind, dass die zweiten Paritätsdecodiereinrichtungen (42) die Paritätsdecodierung nach der Verschachtelung einer vorbestimmten Anzahl Δ von Daten beginnen, ohne das Ende der Verschachtelung abzuwarten, wobei die vorbestimmte Anzahl Δ von Daten zwischen einer ersten niedrigeren Anzahl Δi von Daten, die von mindestens einem Parameter der Verschachtelungseinrichtungen (43) abhängt, und einer ersten höheren Anzahl Δs von Daten liegt,

die der Gesamtanzahl von Daten entspricht, die von den Verschachtelungseinrichtungen (43) verarbeitet werden sollen.

**14.** Computerprogrammprodukt, das von einem Telekommunikationsnetz heruntergeladen und/oder in einem computerlesbaren Träger gespeichert ist und/oder von einem Mikroprozessor ausgeführt werden kann, **dadurch gekennzeichnet, dass** es Programmcodeanweisungen für die Durchführung der Schritte des Codierverfahrens nach mindestens einem der Ansprüche 1 bis 7 enthält, wenn es in einem Computer ausgeführt wird.

**15.** Computerprogrammprodukt, das von einem Telekommunikationsnetz heruntergeladen und/oder in einem computerlesbaren Träger gespeichert ist und/oder von einem Mikroprozessor ausgeführt werden kann, **dadurch gekennzeichnet, dass** es Programmcodeanweisungen für die Durchführung der Schritte des Decodierverfahrens nach mindestens einem der Ansprüche 8 bis 11 enthält, wenn es in einem Computer ausgeführt wird.

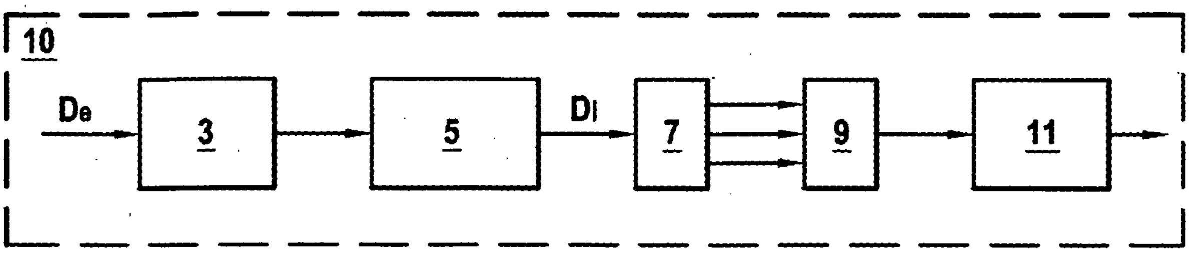


FIG.1A
(ART ANTERIEUR)

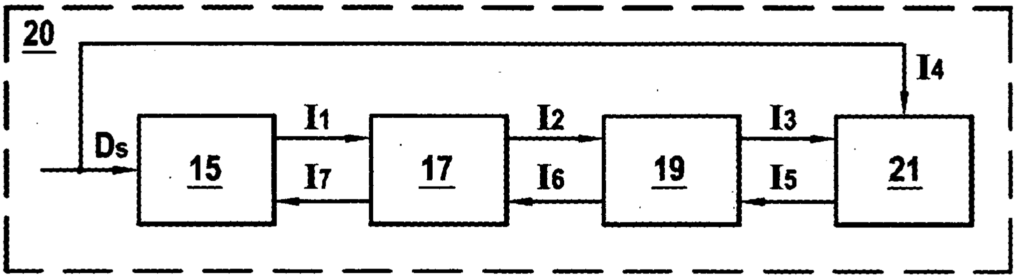


FIG.1B
(ART ANTERIEUR)

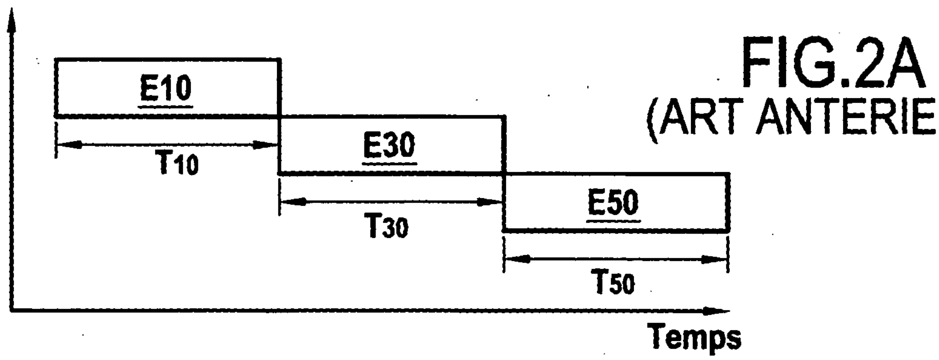


FIG.2A
(ART ANTERIEUR)

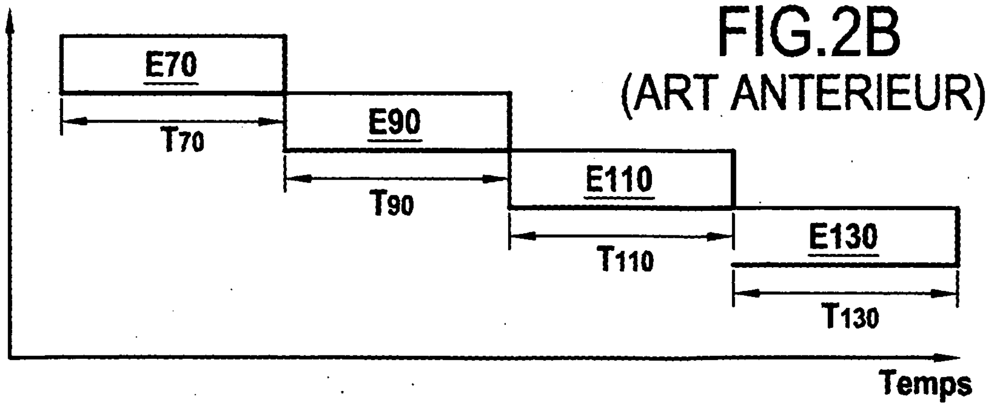


FIG.2B
(ART ANTERIEUR)

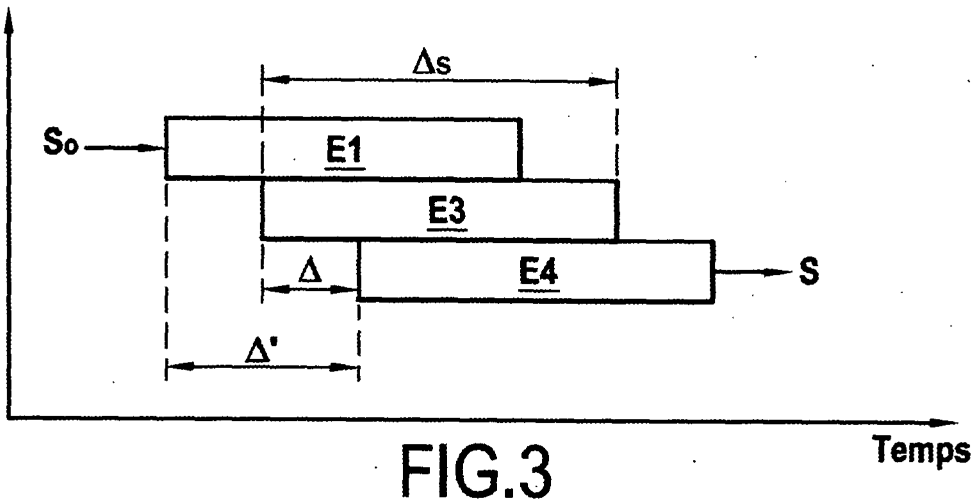


FIG.3

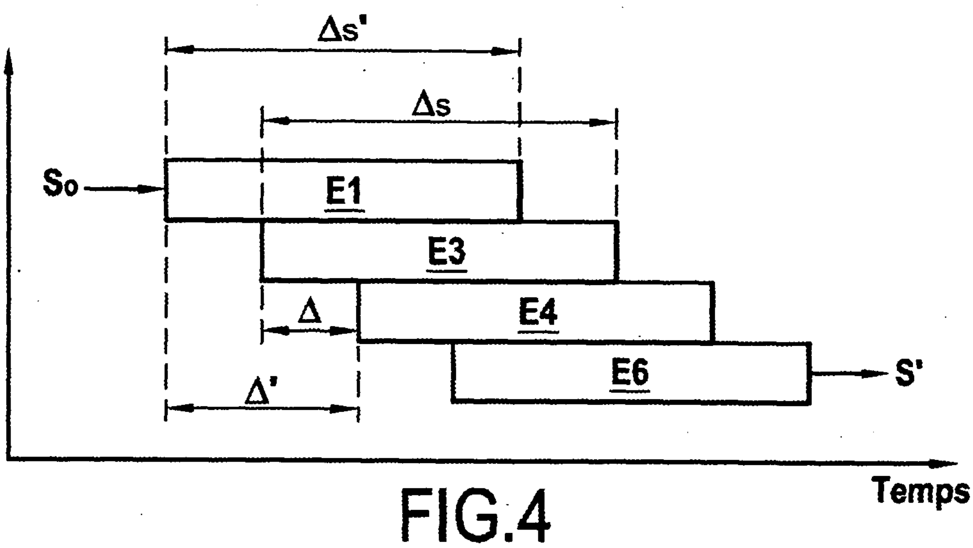


FIG.4

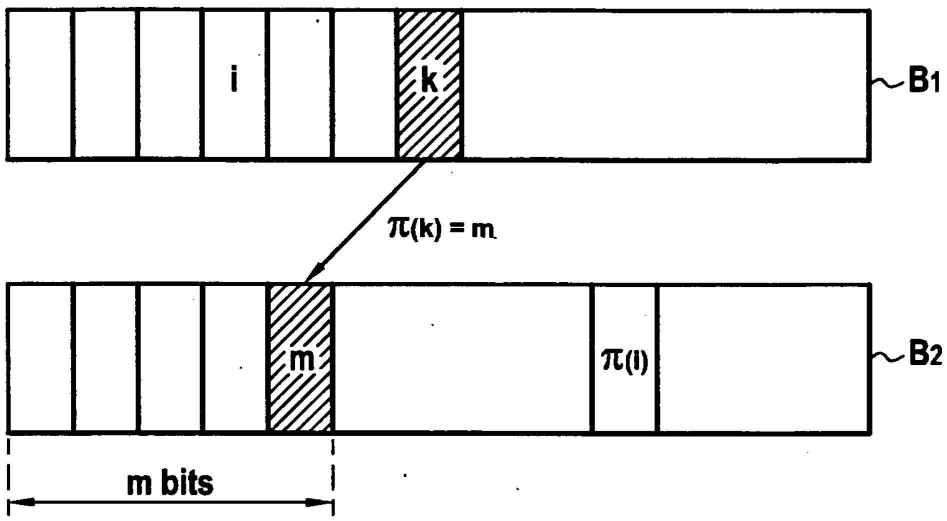
i
k
B1
π(k) = m
m
π(l)
B2
m bits

FIG.5A

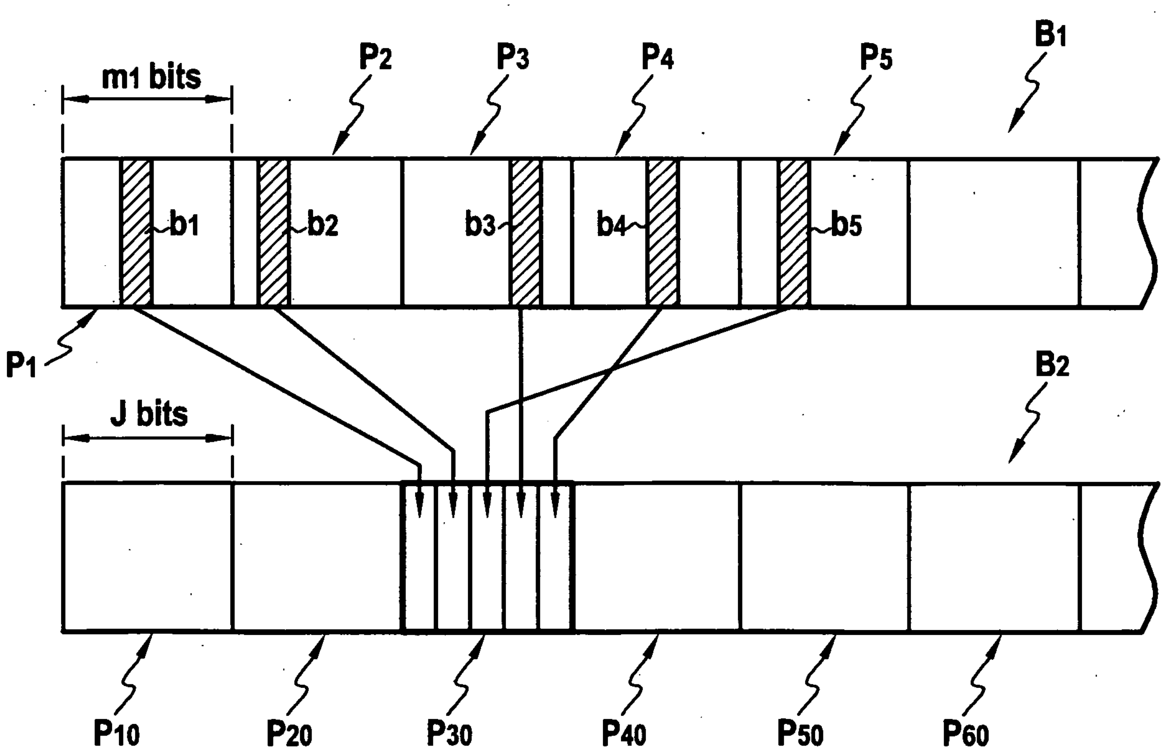
m1 bits
P2
P3
P4
P5
B1
b1
b2
b3
b4
b5
P1
J bits
B2
P10
P20
P30
P40
P50
P60

FIG.5B

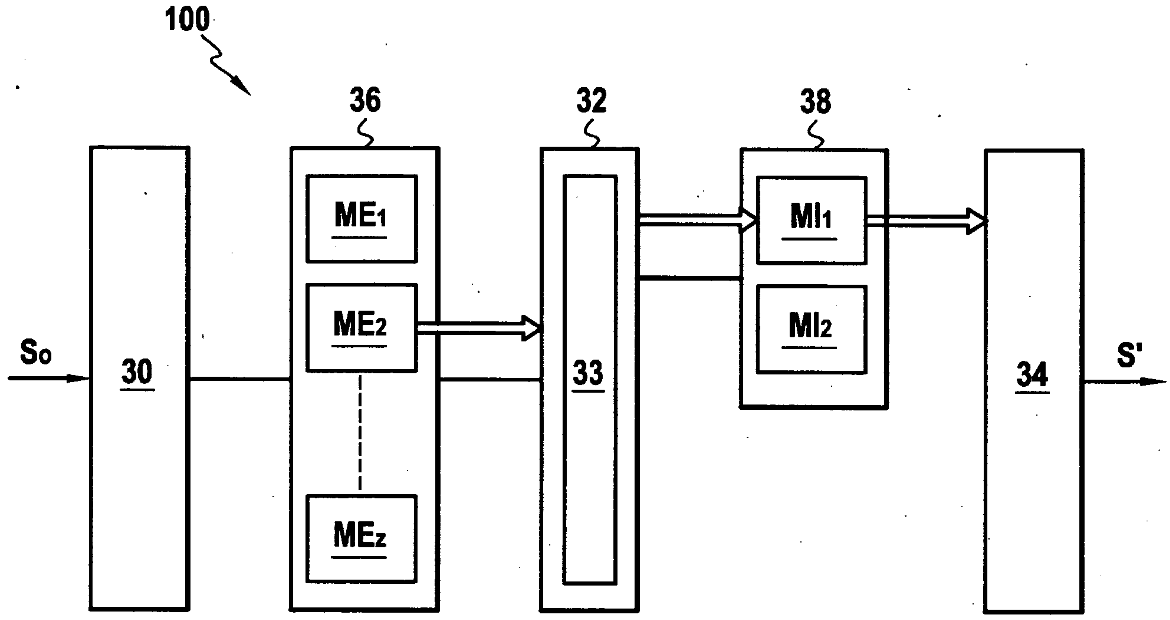
100
36
32
38
ME1
ME2
MEz
MI1
MI2
So
30
33
34
S'

FIG.6

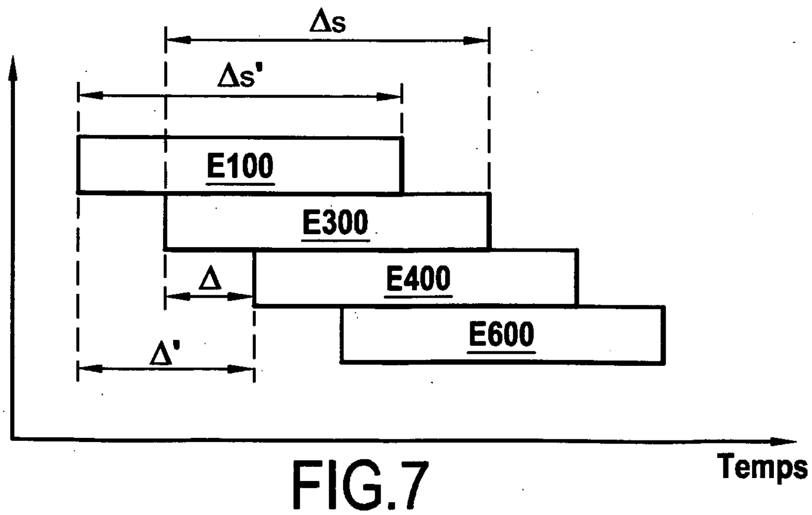
Δs
Δs'
E100
E300
Δ
E400
Δ'
E600
Temps

FIG.7

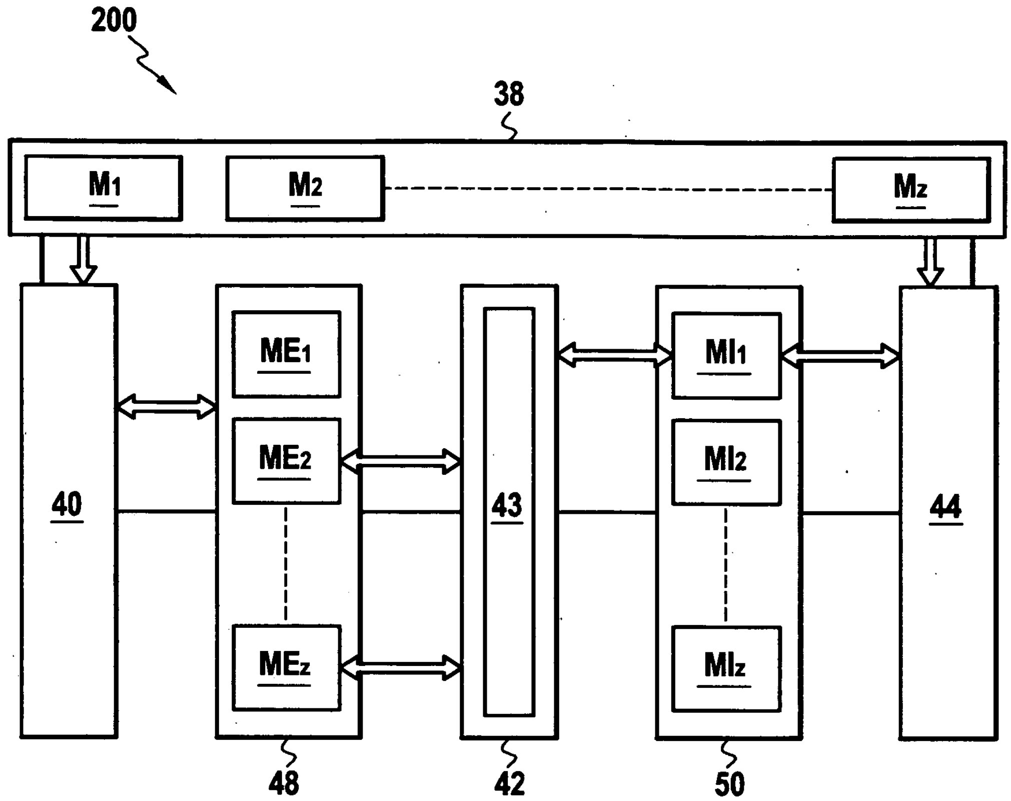
200
38
M1
M2
Mz
ME1
ME2
MEz
MI1
MI2
MIz
40
43
44
48
42
50

FIG.8

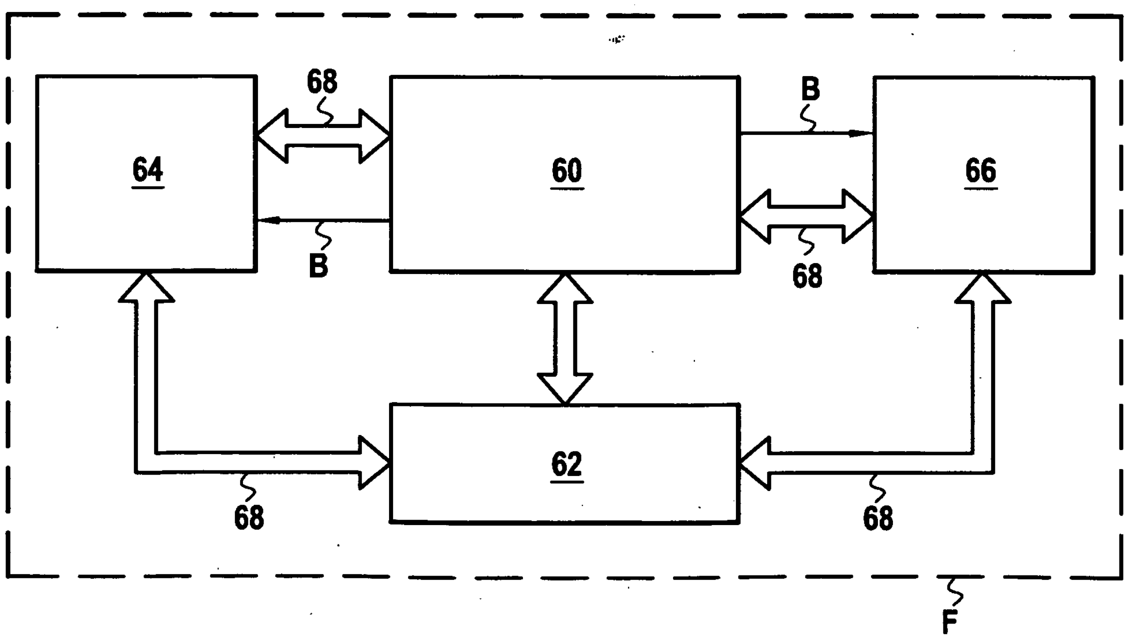
64
68
60
B
66
68
62
68
68
F

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 20050216819 A


### Littérature non-brevet citée dans la description


- Optimal Decoding of Linear Codes for Minimizing Symbol Error Rate. *IEEE Transactions on Information Theory,* Mars 1974, vol. IT-20, 248-287